# EUROPEAN PATENT APPLICATION

(11) **EP 0 681 327 A2**
(43) Date of publication of application: **08.11.1995**
(21) Application number: 95302789.3
(22) Date of filing: 26.04.1995
(51) Int. Cl.: H01L 23/532

(54) **Dual dielectric capping layers for hillock suppression in metal layers in thin film structures**

(30) Priority: 28.04.1994 US 234884
(71) Applicant: XEROX CORPORATION, Rochester New York 14644 (US)
(72) Inventor: Fulks, Ronald T., Mountain View, California 94040 (US); Yao, William W., Los Altos, California 94022 (US); Ho, Jackson H., Palo Alto, California 94301 (US)
(74) Representative: Goode, Ian Roy

(57) **Abstract**

A thin film structure comprising a substrate (52), a metal layer (54) supported by said substrate, a first dielectric layer (56) deposited over the metal layer and a second dielectric layer (58) deposited over the first dielectric layer. The temperature of deposition of the first dielectric layer should be chosen low enough so as to avoid stressing the metal layer and, thus, to keep the metal layer substantially hillock free during the deposition of the first dielectric layer. The second dielectric layer (58) may then be deposited at a higher temperature than the first layer (56).

## Description

The present invention relates in general to metal lines designed to suppress the formation of hillocks in metal layers in thin film structures.

A major challenge in the fabrication of active matrix liquid crystal displays (AMLCDs) is the reduction of gate and data line resistance for high performance. In particular, low resistive gate and data lines in AMLCDs reduces the RC delay response of the active matrix circuitry, resulting in faster screen refresh and also allowing a higher pixel count. Refractory metals such as chromium have too high a resistance for use in high performance displays. Additionally, the cost of refractory metals as standard metal lines is greater than other non-refractory metals. From the standpoint of low resistance and cost, aluminum is a desirable line metal.

Aluminum, however, has an unfortunate tendency to form defects, called "hillocks", under certain deposition conditions. These defects are characterized by protrusions that form on the side of the aluminum that is parallel to and away from the substrate. Hillocks are often times fatal to the correct operation of the IC or active matrix because the protrusions may "punch" through several layers overlying the aluminum. For these reasons, many attempts have been made to suppress the formation of hillocks during the fabrication process.

The first of these techniques employs a separate metal (such as tantalum) capping layer over the aluminum metal. This technique has been regarded as successful for controlling the formation of hillocks in the fabrication process. The drawback, however, is that a separate masking fabrication step is needed to pattern the capping metal - otherwise the capping metal layer, extending over the entire plate, is more likely to cause a short. This is in contrast to a dielectric capping layer which need not be patterned to avoid such an electrical short. This additional masking step for the capping metal adds to the overall cost of fabrication and production.

A second technique caps metal with an oxide layer by means of an anodic process. One such attempt is described in the article: "P-6: Low-Resistivity Tantalum Film for TFT Gate Line" by Shimada et al., published in SID 93 Digest at page 467. Shimada et al. describe the anodic growth of a tantalum oxide layer on tantalum which is additionally capped by a layer of SiNx.

The same anodic process has been used to grow a layer of aluminum oxide on aluminum. The problem with such oxides is that they are generally regarded as poor insulators as well as poor suppressors of hillock formation. It has been reported that small defects in the oxide layer ("pinholes") may form, through which hillocks may protrude. Another drawback with the use of anodic oxide is that the anodic process generally requires the use of potentially contaminating electrolytes and also requires a means of connecting all the patterned lines to achieve anodic growth on all the lines simultaneously.

Thus, there is a need for a cheap, non-contaminating, effective way to suppress the formation of hillocks in metal layers during the fabrication process.

It is therefore an object of the present invention to provide an inexpensive, effective way to suppress hillock formation in metal layers.

According to the present invention, there is provided a thin film structure having a substrate and a metal layer supported by said substrate, said structure designed to suppress the formation of hillocks in said metal layer, said structure comprising: a first dielectric layer deposited on said metal layer at a suitably low temperature below which said metal layer is substantially hillock free; and a second dielectric layer deposited on said first dielectric layer.

The invention also provides a method for making a thin film structure having a substrate and a metal layer, said method for suppressing the formation of hillocks in said metal layer, the steps of said method comprising:
(A) depositing said metal layer on said substrate;
(B) depositing a first dielectric layer on top of said metal layer at a suitably low temperature such that said metal layer remains substantially hillock free; and
(C) depositing a second dielectric layer on top of said first dielectric layer.

In summary, the present invention is a thin film structure comprising a substrate, a metal layer supported by said substrate, a first dielectric layer deposited over the metal layer and a second dielectric deposited over the first dielectric. The temperature of deposition of the first dielectric should be chosen low enough so as to avoid stressing the metal layer and, thus, keeping the metal layer substantially hillock free during the deposition of the first dielectric layer. The second dielectric may then be deposited at a higher temperature than the first layer.

The purpose and advantages of the present invention will be apparent to those skilled in the art from the following detailed description in conjunction with the drawings, in which:-

Figure 1 depicts the formation of a hillock in a metal layer during the fabrication process.

Figure 2A-2B depict two separate attempts to control the growth of hillocks in metal layers.

Figure 3 depicts an embodiment of the dual dielectric layers as made in conformance with the principles of the present invention.

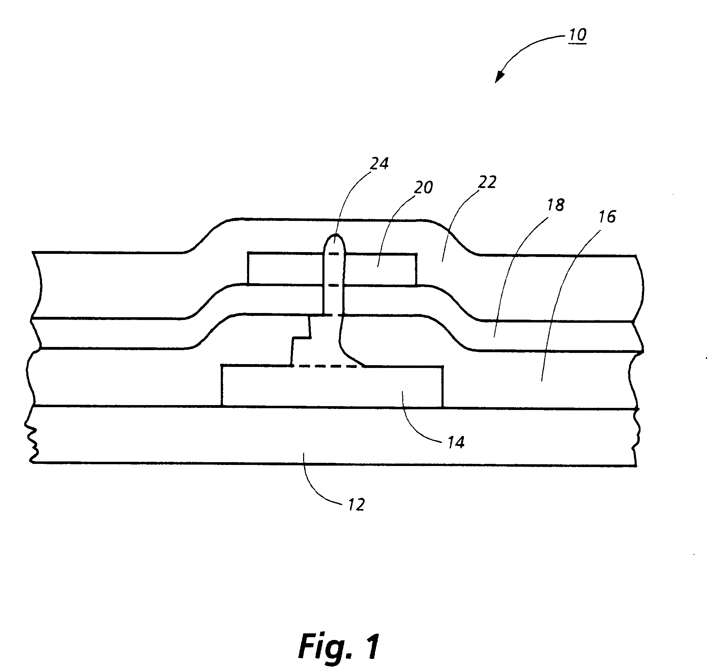

Referring now to Figure 1, the formation of a hillock is depicted in a thin film structure, such as structure 10. While structure 10 is shown comprising several particular layers, it will be appreciated that the choice of any particular layer is merely made for illustrative purposes and, further, that the problem of hillock formation in metal layers is common to various structures using various materials. Additionally, while structure 10 may resemble a thin film transistor (TFT), problems of hillock formation are also fatal to metal line crossover formations, capacitors, or any other structure where the breach of a layer's integrity may cause operational malfunction.

Structure 10 comprises substrate 12 (usually glass, if the structure is part of an AMLCD) upon which a metal layer 14 (e.g. aluminum) is deposited and patterned. A bottom dielectric layer 16 (comprising of SiN or the like) acts as an intervening insulator between metal layer 14 and active layer 18. A top dielectric layer 20 and another metal line 22 are deposited atop active layer 18. As can be seen from Figure 1, hillock 24 has formed from the metal layer 14 and has "punched" through several layers (layers 16, 18, 20, and 22), creating a "short" between metal layer 14 and metal layer 22. A defect, such as the one depicted, is most likely fatal to the correct operation of the structure.

Hillocks, such as hillock 24, form during fabrication. Essentially, metal, such as aluminum, is deposited at relatively high temperature and then patterned after cooling to room temperature. After patterning at room temperature, a dielectric layer, such as SiN layer 16 is deposited at temperatures in the range of 300-380 degrees C. This reheating causes stress in the aluminum metal. Because of a mismatch in the coefficients of thermal expansion between the substrate (usually glass in active matrix liquid crystal displays) and aluminum, the additional stress is relieved in the form of hillocks, whose growth can measure in size from tenths of a micron to several microns.

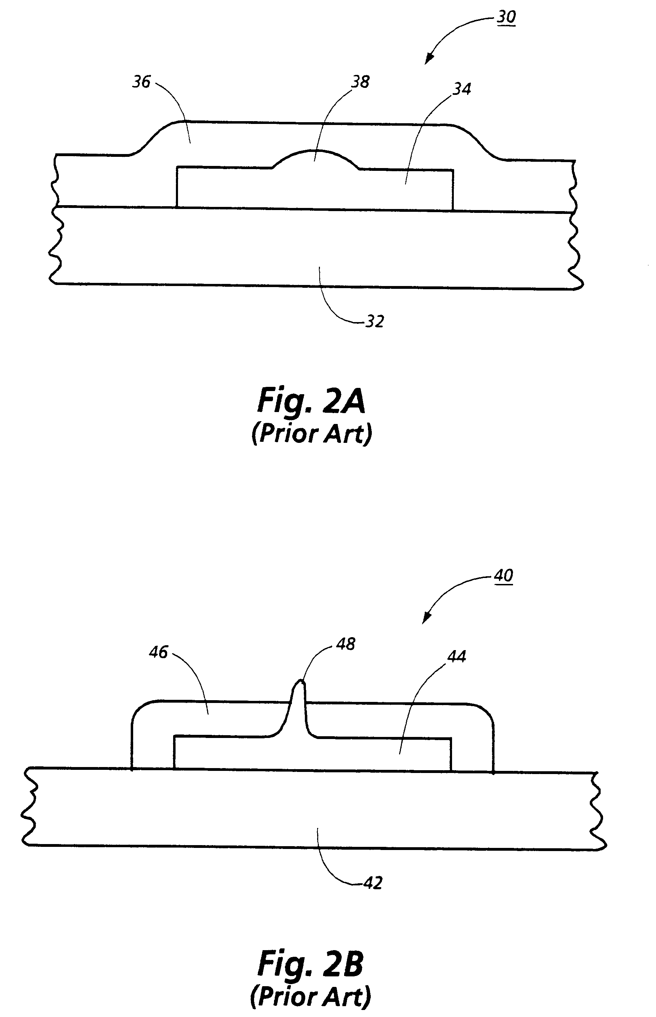

Because hillocks can have such devastating effects on the operation of thin film structures, several attempts have been made to control or suppress their growth in the fabrication process. Figure 2A and 2B depict two such attempts. Figure 2A shows the capping of metal layer 34, such as aluminum, by another metal layer 36, such as tantalum, both deposited upon a substrate 32. As depicted by a slight raise 38 in the surface of the metal layer 34, this method is generally known to be relatively successful in the suppression of hillocks. The drawback with this particular method, however, is increased cost of fabrication. The additional metal capping layer generally requires a separate masking step. Masking is generally known to be a costly fabrication step.

Figure 2B depicts a second attempt at suppressing the formation of hillocks. A metal layer 44 is deposited and patterned on substrate 42. Then, upon the metal layer, an oxide layer 46 is formed from the metal itself by an anodic process (which is similar to electroplating). This method is employed, for example, on a tantalum metal line, as described in the Shimada et al. article referenced above.

Not only does the anodic process itself increase the cost of manufacturing, it has been met with mixed results. As shown in Figure 2B, it is known that small hillocks may form in defects (called "pinholes") occurring in the surface of the oxide layer. Hillocks, such as hillock 48, have been known to form in such pinhole defects - effectively nullifying the desired effect of the oxide as a capping layer.

The present invention proposes the use of dual dielectric layers to suppress the formation of hillocks in deposited metal. The first layer is a dielectric that is deposited in a low temperature environment. The second layer is a more typical high temperature dielectric layer, deposited over the first layer. The first layer is deposited at low temperature in order to avoid undue stress of the metal while the first layer is being deposited.

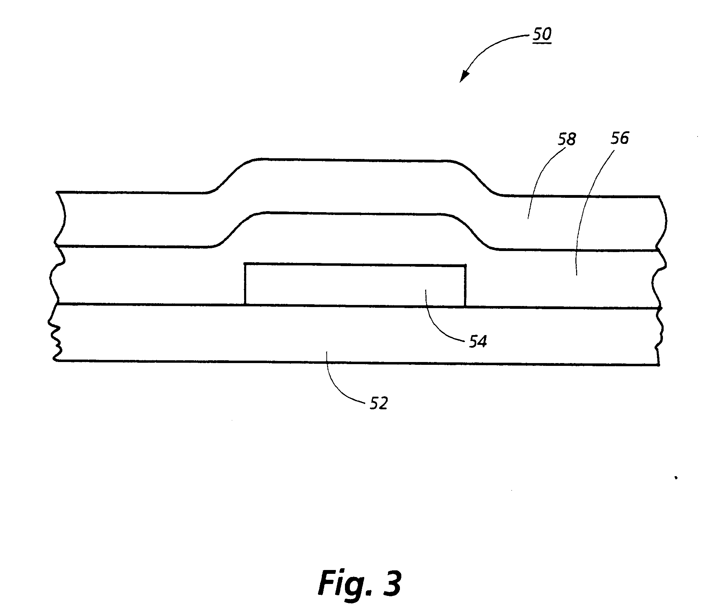

Figure 3 depicts a thin film structure 50 employing an embodiment of the dual dielectric layers as made in conformance with the principles of the present invention. A metal layer 54 is deposited and patterned on substrate 52 to form metal lines 54. On top of the metal layer 54, a first dielectric layer 56 is deposited at low temperature. In one embodiment, this layer is either SiOₓ or SiOₓN_{y} (where the subscripts x and y are variable) deposited by sputtering or standard plasma enhanced chemical vapor deposition (PECVD). If the metal in question is aluminum, then the temperature at which this first layer can be deposited is approximately 150-200 degrees C. The second layer 58 may then be deposited at a higher temperature because the first layer, already formed, aids to suppress the formation of hillocks. In one embodiment, the second dielectric is SiNₓ which is deposited using either sputter deposited or PECVD at 350 degrees C. The second dielectric, deposited at a higher temperature, compensates for the poorer dielectric qualities of the low temperature-deposited first dielectric because, as a general rule, the quality of a dielectric is proportional to its deposition temperature.

It will be appreciated that the present invention should not be limited to the particular choice of metal, dielectric materials or the particular temperatures listed above. The important feature of the present invention is that the temperature of the deposition of the first dielectric should be high enough to achieve a satisfactory deposition of the first dielectric and yet low enough so as not to unduly stress the metal and cause formation of hillocks.

In summary, the present invention is a thin film structure comprising a metal layer, a first dielectric layer deposited over the metal and a second dielectric deposited over the first dielectric. The temperature of deposition of the first dielectric should be chosen to be low enough so as to avoid stressing the metal layer. The second dielectric may then be deposited at a higher temperature than the first layer.

The present invention provides protection against the formation of hillocks by providing a first dielectric capping layer that works to suppress hillocks as the second dielectric layer is deposited at a comparatively higher temperature.

## Claims

1. A thin film structure having a substrate (52) and a metal layer (54) supported by said substrate, said structure designed to suppress the formation of hillocks in said metal layer, said structure comprising:
a first dielectric layer (56) deposited on said metal layer at a suitably low temperature below which said metal layer is substantially hillock free; and
a second dielectric layer (58) deposited on said first dielectric layer.

2. The thin film structure as recited in claim 1 wherein said metal layer comprises aluminum.

3. The thin film structure as recited in claim 1 or claim 2 wherein said first dielectric layer comprises SiOₓ or SiOₓN_{y}.

4. The thin film structure as recited in any one of claims 1 to 3 wherein said first dielectric layer is deposited by sputter deposition or by chemical vapor deposition.

5. The thin film structure as recited in any one of claims 1 to 4 wherein said metal layer comprises aluminum; and said suitably low temperature is less than 250 degrees C, preferably between 150 and 200 degrees C.

6. The thin film structure as recited in any one of claims 1 to 5 wherein said second dielectric comprises SiN_{y}.

7. A method for making a thin film structure having a substrate (52) and a metal layer (54), said method for suppressing the formation of hillocks in said metal layer, the steps of said method comprising:
(A) depositing said metal layer (54) on said substrate (52);
(B) depositing a first dielectric layer (56) on top of said metal layer at a suitably low temperature such that said metal layer remains substantially hillock free; and
(C) depositing a second dielectric layer (58) on top of said first dielectric layer.

8. The method as recited in claim 7 wherein said metal layer comprises aluminum.

9. The method as recited in claim 7 or claim 8 wherein said first dielectric layer comprises SiOₓ or SiOₓN_{y}.

10. The method as recited in any one of claims 7 to 9 wherein said second dielectric comprises SiN_{y}.
